# FASCICULE DE BREVET EUROPEEN

(11) **EP 3 448 139 B1**
(45) Date de publication et mention de la délivrance du brevet: **27.10.2021**
(21) Numéro de dépôt: 18189620.0
(22) Date de dépôt: 17.08.2018
(51) Int. Cl.: H05K 7/20, H05K 7/14

(54) **EQUIPEMENT ÉLECTRONIQUE COMPRENANT UNE BRIDE DE FIXATION**
ELEKTRONISCHE AUSRÜSTUNG, DIE EINEN BEFESTIGUNGSFLANSCH UMFASST
ELECTRONIC EQUIPMENT COMPRISING AN ATTACHMENT FLANGE

(30) Priorité: 18.08.2017 FR 1757757
(43) Date de publication de la demande: 27.02.2019
(73) Titulaire: ALSTOM Transport Technologies, 93400 Saint-Ouen (FR)
(72) Inventeur: DELVAL, Damien, 59600 Assevent (FR)
(74) Mandataire: Lavoix

(56) Documents cités:
- EP-A1- 1 259 104
- FR-A1- 2 875 374
- JP-A- H06 163 770
- JP-A- H11 251 499
- US-A1- 2013 016 481
- US-A1- 2015 371 920

## Description

La présente invention concerne un équipement électronique d'un véhicule ferroviaire, du type comprenant au moins :
- un module électronique comprenant au moins une paroi définissant un volume interne ;
- un ensemble de composants électroniques disposés à l'intérieur du volume interne,
- un module de refroidissement, configuré pour refroidir les composants électroniques en évacuant vers l'extérieur du volume interne au moins une partie d'une chaleur dissipée par les composants électroniques, ledit module de refroidissement étant disposé à l'extérieur du volume interne, et
- une bride interposée entre le module de refroidissement et la paroi du module électronique, ladite bride étant en contact avec le module de refroidissement et avec ladite paroi du module électronique.

L'invention concerne notamment le domaine des véhicules ferroviaires, l'équipement électronique étant destiné à être embarqué dans un véhicule ferroviaire.

Le module électronique de l'équipement électronique est par exemple un convertisseur d'énergie électrique.

On connaît du document FR 2 875 374 un convertisseur d'énergie électrique du type précité. Le convertisseur comprend une section de circuit de puissance, une section de circuit de commande logées dans un volume interne défini par des parois du module électronique. Le convertisseur comprend également un premier radiateur configuré pour diffuser une partie de la chaleur générée par la section de circuit de puissance vers l'extérieur du volume interne.

US 2013/016481 A1 décrit un convertisseur de puissance électrique comprenant un boîtier de convertisseur de puissance électrique, une section de montage d'unité, et une unité interne montée sur la section de montage d'unité, l'unité interne comprenant une pluralité de supports de fixation.

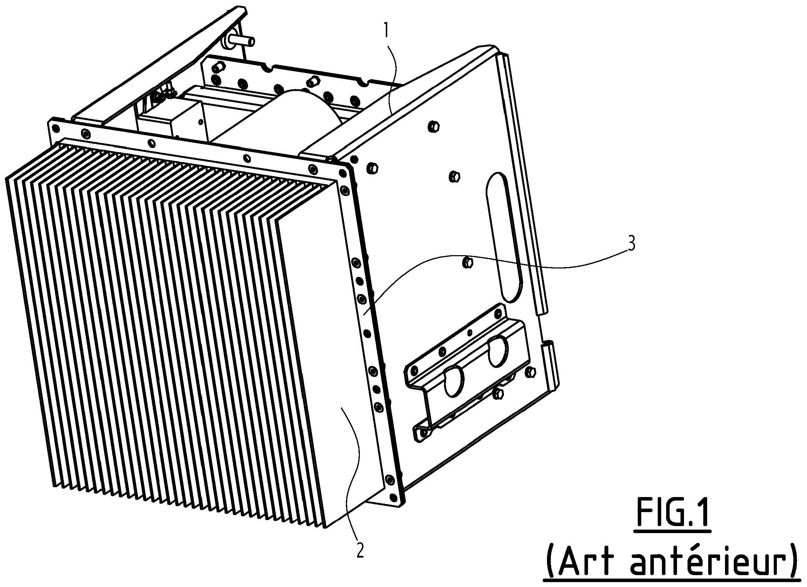

Un tel convertisseur d'énergie est généralement monté à l'intérieur d'un coffre comprenant plusieurs convertisseurs d'énergie. La fixation entre le radiateur et le module électronique et entre le module électronique et le coffre se fait par une bride s'étendant entre le module électronique et le module de refroidissement à l'extérieur du volume interne selon une direction perpendiculaire à la direction d'assemblage comme représenté sur la Fig. 1, dans laquelle le module électronique est désigné par la référence numérique 1, le module de refroidissement par la référence numérique 2 et la bride par la référence numérique 3. Une telle bride permet de fixer le coffre au radiateur en laissant les composants électroniques au contact du radiateur et d'éviter d'avoir à fixer le coffre au radiateur par l'intérieur du volume défini par le coffre, ce qui pourrait entraîner des pertes de rondelles ou autre dans le volume du coffre et causer des disfonctionnements des composants électroniques. Le convertisseur est ensuite monté dans une ouverture d'une paroi du coffre en fixant la bride à la périphérie de l'ouverture grâce à des vis traversant la bride selon la direction d'assemblage.

On cherche constamment à augmenter le volume interne du module électronique afin de pouvoir y ajouter des composants électroniques. Cependant, une telle augmentation du volume interne nécessiterait d'augmenter la taille de la bride, ce qui n'est pas possible car le coffre ne doit pas augmenter de volume, puisque celui-ci est dimensionné pour occuper un volume prédéfini à l'intérieur du véhicule ferroviaire. Il n'est donc pas possible d'agrandir l'ouverture dans la paroi du coffre pour la réception d'une bride plus grande.

L'un des buts de l'invention est de pallier les inconvénients ci-dessus en proposant un équipement électronique comprenant un module électronique définissant un volume interne plus grand, sans pour autant augmenter l'encombrement de cet équipement électronique.

A cet effet, l'invention concerne un équipement électronique selon la revendication 1.

En prévoyant que la paroi recouvre la bride selon la direction de fixation afin de permettre la fixation de la paroi dans l'épaisseur de la bride, il est possible d'augmenter le volume interne du module électronique selon la direction de fixation tout en conservant une bride de même dimension selon cette direction de fixation. Ainsi, le volume interne est augmenté sans augmenter l'encombrement de l'équipement électronique.

Des caractéristiques optionnelles de l'équipement électronique sont définies aux revendications 2 à 11.

D'autres aspects et avantages de l'invention apparaîtront à la lecture de la description qui suit, donnée à titre d'exemple et faite en référence aux dessins annexés, dans lesquels :
- la figure 1 est une représentation schématique en perspective d'un équipement électronique selon l'art antérieur,
- la figure 2 est une représentation schématique en perspective d'une partie d'un équipement électronique selon l'invention,
- la figure 3 est une représentation schématique en coupe selon un plan contenant la direction d'assemblage d'une partie de l'équipement électronique de la figure 2,
- la figure 4 est une représentation schématique en coupe selon un plan contenant la direction d'assemblage d'une autre partie de l'équipement électronique de la figure 2,
- la figure 5 est une représentation schématique en perspective du coffre de l'équipement électronique selon l'invention, et
- la figure 6 est une représentation schématique agrandie de la zone VI de la figure 5.

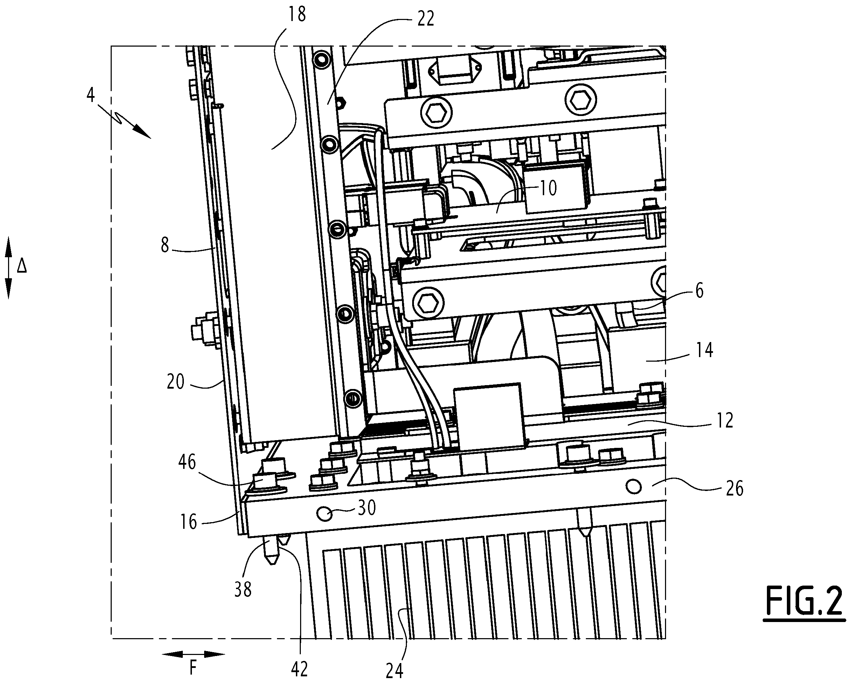

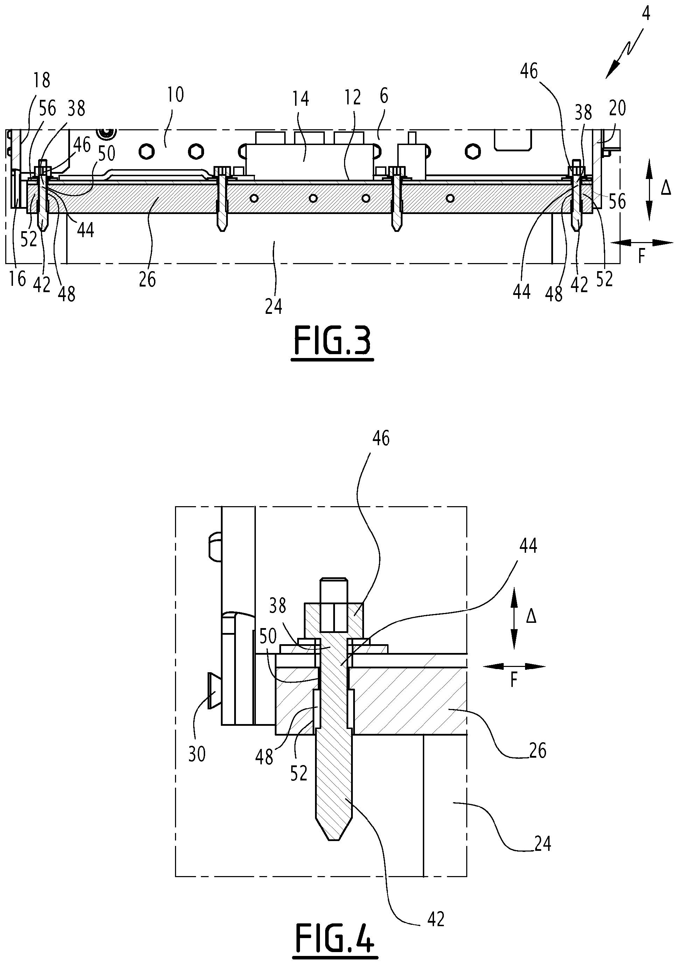

En référence aux figures 2 et 3, on décrit un équipement électronique 4 d'un véhicule ferroviaire.

L'équipement électronique 4 comprend un module électronique 6 comprenant au moins une paroi 8 définissant un volume interne 10, une carte électronique 12 et un ensemble de composants électroniques 14 étant disposé dans le volume interne 10.

Le volume interne 10 est par exemple délimité par quatre parois latérales 8 définissant entre elles un volume interne 10 de forme sensiblement parallélépipédique. Pour des raisons de lisibilité, on notera que la paroi latérale 8 devant masquer le volume interne 10 sur la figure 2 n'a pas été représentée. Chaque paroi latérale 8 s'étend, dans une direction d'assemblage Δ, sensiblement orthogonale à la carte électronique 12, entre un bord proximal 16 et un bord distal. Chaque paroi latérale 8 est reliée à deux parois latérales qui lui sont adjacentes. Chaque paroi latérale 8 comprend une face interne 18 orientée vers le volume interne 10 et une face externe 20 orientée vers l'extérieur du volume interne 10. Chaque paroi latérale 8 est par exemple sensiblement plane entre ses bords proximal 16 et distal. Deux des parois comprennent par exemple deux bords latéraux 22 s'étendant selon la direction d'assemblage Δ de part et d'autre de la partie plane de la paroi et permettant la fixation d'une autre paroi latérale 8. Les bords latéraux 22 forment chacun un décrochement sensiblement parallèle à la paroi latérale 8 à laquelle il est fixé par exemple par vissage.

Le volume interne 10 peut en outre être fermé du côté du bord distal des parois latérales 8 par un capot (non représenté) s'étendant sur le bord distal des parois latérales 8 sensiblement perpendiculairement à celles-ci. Le module électronique 6 forme ainsi une enceinte délimitée par les parois latérales 8 et le capot. Cette enceinte est ouverte, i.e. ne comprend pas de deuxième capot longitudinal qui serait relié aux bords proximaux 16 des parois latérales 8.

L'équipement électronique 4 est par exemple un onduleur, ou un redresseur, ou encore un convertisseur de fréquence comportant un redresseur et un onduleur connecté en sortie du redresseur. Comme connu en soi, un tel convertisseur d'énergie électrique comporte un ou plusieurs bras de commutation, chaque bras de commutation comportant au moins deux interrupteurs connectés en série et reliés entre eux en un point milieu. Le convertisseur d'énergie électrique comprend par exemple un onduleur apte à convertir une énergie continue reçue en entrée du convertisseur en une énergie alternative délivrée en sortie du convertisseur. Un tel onduleur comprend deux bornes d'entrées, une borne de sortie pour chaque phase de l'énergie alternative délivrée et un bras de commutation par phase. Chaque bras de communication est alors connecté entre les deux bornes d'entrée, son point milieu étant connecté à la borne de sortie pour la phase correspondante.

Comme indiqué précédemment, la carte électronique 12 et les composants électroniques 14 sont disposés à l'intérieur du volume interne 10. Plus particulièrement, la carte électronique 12 s'étend entre les parois latérales, sensiblement perpendiculairement à celles-ci, au voisinage du bord proximal 16.

Les composantes électroniques 14 sont connectés à la carte électronique 12. Les composants électroniques comprennent par exemple des transistors.

Selon un mode de réalisation, l'ensemble de composants électroniques 14 comporte au moins un module de commutation, chaque module de commutation étant formé de deux interrupteurs connectés en série. Chaque interrupteur comporte par exemple un transistor bipolaire à grille isolée, également appelé IGBT (de l'anglais *Insulated Gate Bipolar Transistor*)*.* En variante, chaque interrupteur comporte un transistor bipolaire, ou un transistor de type JFET (de l'anglais *Junction Field Effect Transistor*)*,* ou encore un thyristor, tel qu'un thyristor à extinction par la gâchette, ou GTO (de l'anglais *Gate Turn-Off Thyristor*)*.*

L'équipement électronique 4 comprend en outre un module de refroidissement 24 s'étendant en dehors du volume interne 10 et monté en contact direct avec les composants électroniques 14. Dans une configuration, les composants électroniques 14 sont fixés au module de refroidissement 24.

Le module de refroidissement forme un deuxième capot longitudinal fermant le volume interne 10 du côté des bords proximaux 16 des parois latérales 8.

Le module de refroidissement 24 est configuré pour refroidir l'ensemble des composants électroniques 14, en évacuant vers l'extérieur du volume interne 10 au moins une partie de la chaleur dissipée par les composants électroniques 14, en fonctionnement. Le module de refroidissement 24 est également apte à refroidir la carte électronique 12.

Le module de refroidissement 24 comprend par exemple un radiateur à ailettes, comme représenté sur les figures, un flux d'air étant alors destiné à circuler entre les ailettes du radiateur pour évacuer la chaleur dissipée par les composants électroniques 14 lors de leur fonctionnement. En variante ou en complément, le module de refroidissement 24 comporte un module de Peltier ou encore un caloduc.

L'équipement électronique 4 comprend en outre une bride 26 interposée entre le module de refroidissement 24 et au moins une paroi latérale 8 du module électronique 4, la bride 26 étant en contact avec le module de refroidissement 24 et avec le bord proximal 16 d'au moins une paroi 8.

La bride 26 est par exemple réalisée en un matériau thermiquement isolant, par exemple réalisée en Muscotherm®, epoglass G11 ou polyglass® GPO. Ainsi, la bride 26 est apte à éviter la formation d'un pont thermique entre le module de refroidissement 24, via la bride 26, et le module électronique 6.

Dans l'exemple illustré, la bride 26 est interposée entre le module de refroidissement 24 et chacune des quatre parois latérales 8, la bride 26 étant en contact avec le module de refroidissement 24 et avec le bord proximal 16 de chacune des quatre parois latérales 8.

La bride 26 forme un cadre définissant une ouverture délimitée par une périphérie de la bride 26, l'ouverture permettant le contact entre les composants électroniques 14 et le module de refroidissement 24. Vers l'extérieur de la bride 26, la périphérie comprend au moins une face de périphérie 28 s'étendant selon l'épaisseur de la bride 26, mesurée selon la direction d'assemblage Δ, sensiblement parallèlement à la paroi 8. Selon l'exemple illustré sur les figures, la bride 26 comprend quatre faces de périphérie 28, chacune étant sensiblement parallèle à l'une des parois latérales 8.

Le bord proximal 16 de chaque paroi latérale 8 s'étend en regard et recouvre la face de périphérie 28 correspondante de la bride 26 selon une direction de fixation F, sensiblement perpendiculaire à la direction d'assemblage Δ et à la paroi latérale 8, comme représenté sur les figures 3 et 4, c'est-à-dire que la face interne 18 de la paroi latérale 8 est appliquée contre la face de périphérie 28 de la bride 26 au niveau de son bord proximal 16. Plus particulièrement, le bord proximal 16 s'étend sur toute l'épaisseur de la bride 26 selon la direction d'assemblage Δ.

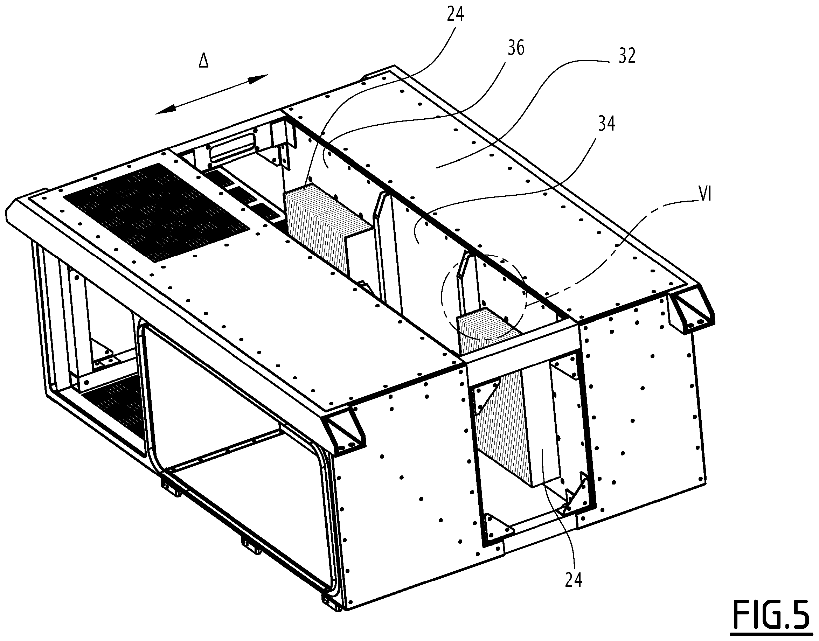

L'épaisseur de la bride 26, et donc la distance de recouvrement entre le bord proximal 16 et la paroi de périphérie 28 correspondante, est agencée pour permettre la fixation de la paroi latérale 8 à la périphérie de la bride 26 par au moins un premier élément de fixation 30 s'étendant selon la direction de fixation F et traversant le bord proximal 16 et étant ancré dans l'épaisseur de la bride 26. A cet effet, l'épaisseur de la bride 26 est par exemple sensiblement comprise entre 15 mm et 20 mm. Ainsi, l'équipement électronique 4 selon l'invention comprend une bride 26 dite « épaisse » par rapport aux équipements de l'art antérieur, dans lesquels on cherche à réduire l'épaisseur de la bride. Le premier élément de fixation 30 est par exemple une vis, vissée dans l'épaisseur de la bride 26 en passant au travers du bord proximal 16 de la paroi latérale 8, comme représenté sur les figures 3 et 5. Selon un mode de réalisation, plusieurs premiers éléments de fixation 30 fixent chaque paroi latérale 8 à la face de périphérie 28 correspondante de la bride.

Une telle fixation des parois latérales 8 sur la bride 26 permet d'augmenter le volume interne 10 du module électronique 6 en décalant vers l'extérieur les parois latérales 8 selon la direction de fixation, par rapport aux équipements électroniques de l'art antérieur, dans lesquels la bride s'étend autour des parois latérales. Selon l'invention, la bride 26 s'étend dans le volume interne 10 et non à l'extérieur de celui-ci.

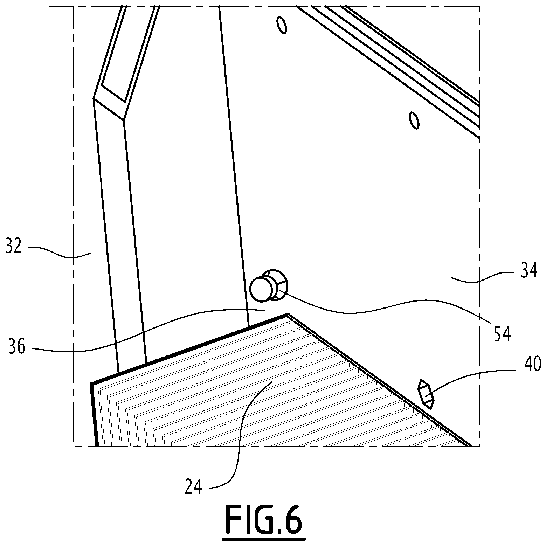

L'ensemble formé par le module électronique 6 et le module de refroidissement 24 est en outre fixé à l'intérieur d'un coffre 32, représenté sur les figures 5 et 6. Plus particulièrement, cet ensemble est monté dans une ouverture pratiquée dans une paroi 34 du coffre 32 de sorte que le module électronique 6 s'étende d'un côté de cette paroi 34 et que le module de refroidissement 24 s'étende de l'autre côté de cette paroi 34. La fixation de l'ensemble à la paroi 34 se fait sur le bord 36 de l'ouverture pratiquée dans la paroi 34 en fixant la bride 26 à ce bord 36 par au moins un deuxième élément de fixation 38, représenté sur les figures2 à 4.

Le deuxième élément de fixation 38 est par exemple formé par une vis imperdable traversant la bride 26 selon la direction d'assemblage Δ, entre les faces de périphérie 28 et l'ouverture de la bride 26, et introduit dans un alésage 40 prévu sur le bord 36 de l'ouverture de la paroi 34, comme représenté sur la figure 6, dans laquelle l'un des alésages 40 a été représenté sans élément de fixation pour une meilleure lisibilité.

Le deuxième élément de fixation 38 comprend ainsi une partie extrême filetée 42 et une partie de tige 44 d'un diamètre inférieur au diamètre de la partie extrême filetée 42. La partie de tige 44 s'étend entre la partie extrême filetée 42 et une tête d'actionnement 46, par laquelle la vis imperdable peut être vissée et dévissée. Le deuxième élément de fixation 38 est par exemple réalisé d'une seule pièce.

La bride 26 comprend un orifice 48 de réception du deuxième élément de fixation 38. L'orifice 48 comprend, du côté du module électronique 6, une partie taraudée 50 sensiblement complémentaire de la partie extrême filetée et, du côté du module de refroidissement, une partie 50 de diamètre supérieur au diamètre de la partie taraudée 50, comme plus particulièrement visible sur la figure 4. Ainsi, en introduisant le deuxième élément de fixation 38 du côté du module électronique 6, on peut visser la partie extrême filetée 42 dans la partie taraudée 50 puis faire passer cette partie extrême filetée 42 dans la partie 52 de diamètre supérieur. La partie de tige 44 se trouve alors dans la partie taraudée 50, comme représenté sur les figures 3 et 4. On comprend donc que le deuxième élément de fixation 38 est alors libre de se déplacer par rapport à l'orifice 48, notamment en rotation autour de son axe, tout en restant solidaire de la bride 26, en étant empêchée de sortir de l'orifice 48, sauf par dévissage de la partie extrême filetée 42 hors de la partie taraudée 50.

On peut ainsi manipuler l'ensemble formé du module électronique 4 et du module de refroidissement 24 avec le deuxième élément de fixation 38, sans perdre celui-ci. Cela permet un montage de l'ensemble sur la paroi 34 du coffre en vissant le deuxième élément de fixation 38 dans l'alésage 40 de la paroi selon la direction d'assemblage Δ, ce vissage étant possible du fait que le deuxième élément de fixation 38 reste mobile en rotation par rapport à l'orifice 48. La fixation du deuxième élément de fixation 38 à la paroi 34 se fait par exemple en vissant la deuxième partie extrême filetée 42 dans un écrou serti étanche 54, ou « clufix », préalablement fixé à l'alésage 40, comme représenté sur la figure 6. Un tel écrou serti étanche 54 permet d'assurer une étanchéité entre les deux côtés de la paroi 34 lorsque l'ensemble formé du module électronique 4 et du module de refroidissement 24 est fixé dans l'ouverture de la paroi 34 du coffre 32. Le serrage au couple de la vis imperdable est par exemple rendu possible par deux rondelles 56 s'étendant autour de la partie de tige 44 entre la bride 26 et la tête d'actionnement 46, comme représenté sur la Fig. 3.

L'ensemble formé du module électronique 4 et du module de refroidissement 24 est par exemple fixé à la paroi 34 du coffre 32 par plusieurs deuxièmes éléments de fixation 38 répartis sur le pourtour de la bride 26, comme représenté sur les figures 2 et 3.

Les deuxièmes éléments de fixation 38 s'étendent à l'intérieur du volume interne 10 du côté du module électronique 4 car les parois latérales 8 s'étendent du côté extérieur de la bride 26 afin d'augmenter le volume interne, comme décrit précédemment. Un tel agencement des éléments de fixation 38 à l'intérieur du volume interne 10 n'est pas gênant car les éléments de fixation 38 étant formés par des vis imperdable, il n'y a pas de risque de perte d'éléments, tels que des rondelles ou des écrous, à l'intérieur du volume interne 10, ce qui pourrait causer des disfonctionnements des composants électroniques.

Le coffre 32 peut recevoir plusieurs ensembles formés d'un module électronique 6 et d'un module de refroidissement 24, comme représenté sur la Fig. 5.

L'équipement électronique décrit ci-dessus permet d'augmenter le volume interne 10 du module électronique 6 afin de pouvoir y ajouter des composants électroniques, sans augmenter l'encombrement de ce module puisque la taille de la bride n'a pas besoin d'être augmentée dans la direction de fixation. En outre, la fixation du module électronique sur le coffre se fait par l'intérieur du volume interne 10 sans pour autant entraîner un risque de perte de pièces libres dans ce volume.

## Revendications

1. Equipement électronique (4) d'un véhicule ferroviaire, comprenant au moins :
- un module électronique (6) comprenant au moins une paroi (8) définissant un volume interne (10) ;
- un ensemble de composants électroniques (14) disposés à l'intérieur du volume interne (10),
- un module de refroidissement (24), configuré pour refroidir les composants électroniques (14) en évacuant vers l'extérieur du volume interne (10) au moins une partie d'une chaleur dissipée par les composants électroniques (14), ledit module de refroidissement (24) étant disposé à l'extérieur du volume interne (10), et
- une bride de fixation (26) interposée entre le module de refroidissement (24) et la paroi (8) du module électronique (6), ladite bride de fixation (26) étant en contact avec le module de refroidissement (24) et avec ladite paroi (8) du module électronique (6), **caractérisé en ce que** la bride (26) comprend au moins une face de périphérie (28) s'étendant selon l'épaisseur de la bride (26) sur l'extérieur de la bride (26), et
**en ce que** la paroi (8) s'étend en regard et recouvre la face de périphérie (28) de la bride (26) selon une direction de fixation (F) sensiblement perpendiculaire à la paroi (8), ladite paroi (8) étant fixée à ladite face de périphérie (28) de la bride (26) par au moins un premier élément de fixation (30) s'étendant selon ladite direction de fixation (F).

2. Equipement électronique selon la revendication 1, dans lequel plusieurs éléments de fixation fixent chaque paroi (8) à la face de périphérie (28) de la bride (26).

3. Equipement électronique selon la revendication 1 ou 2, comprenant en outre au moins un deuxième élément de fixation (38) agencé pour fixer le module électronique (6) et le module de refroidissement (24) à une paroi (34) d'un coffre (32), ledit deuxième élément de fixation (38) s'étendant au travers de la bride (26) selon une direction d'assemblage sensiblement perpendiculaire à la direction de fixation (F) et s'étendant dans le volume interne (10).

4. Equipement électronique selon la revendication 3, dans lequel le deuxième élément de fixation (38) est une vis imperdable.

5. Equipement selon la revendication 3 ou 4, dans lequel le deuxième élément de fixation (38) comprend une partie extrême filetée (42) et une partie de tige (44) d'un diamètre inférieur au diamètre de la partie extrême filetée (42), la bride comprenant un orifice (48) présentant une partie taraudée (50) sensiblement complémentaire de la partie extrême filetée (42), le deuxième élément de fixation (38) étant vissé par sa partie extrême filetée (42) dans la partie taraudée (50) puis étant mobile en translation par rapport à l'orifice (48) après le vissage lorsque la partie de tige (44) s'étend dans la partie taraudée (50) tout en restant solidaire de la bride (26).

6. Equipement électronique selon la revendication 5, dans lequel l'orifice (48) comprend une partie (52) de diamètre supérieur au diamètre de la partie taraudée (50), ladite partie (52) de diamètre supérieur recevant la partie extrême filetée (42) du deuxième élément de fixation (38) après le vissage de ladite partie extrême filetée (42) dans la partie taraudée (50).

7. Equipement électronique selon l'une quelconque des revendications 3 à 6, dans lequel la paroi (34) du coffre (32) comprend une ouverture, la bride (26) étant fixée sur le bord (36) de ladite ouverture par le deuxième élément de fixation (38) de sorte que le module électronique (6) s'étende d'un côté de la paroi (34) et le module de refroidissement (24) de l'autre côté de la paroi (34).

8. Equipement électronique selon l'une quelconque des revendications 1 à 7, dans lequel la bride (26) présente une épaisseur sensiblement comprise entre 15 mm et 20 mm.

9. Equipement électronique selon l'une quelconque des revendications 1 à 8, dans lequel la bride (26) est réalisée en un matériau thermiquement isolant.

10. Equipement électronique selon l'une quelconque des revendications 1 à 9, dans lequel le module électronique (6) comprend au moins quatre parois latérales (8), s'étendant chacune en regard d'une face de périphérie (28) correspondante de la périphérie de la bride (26) selon la direction de fixation (F), chaque paroi latérale (8) étant fixée à la face de périphérie (28) par au moins un premier élément de fixation (30) s'étendant selon ladite direction de fixation (F).

11. Equipement électronique selon l'une quelconque des revendications 1 à 10, dans lequel le module électronique (6) est un convertisseur d'énergie électrique.

## Patentansprüche

1. Elektronische Ausrüstung (4) eines Schienenfahrzeugs, mindestens umfassend:
- ein Elektronikmodul (6), umfassend mindestens eine Wand (8), die ein Innenvolumen (10) begrenzt;
- eine Reihe von elektronischen Komponenten (14), die im Innern des Innenvolumens (10) angeordnet sind,
- ein Kühlmodul (24), das konfiguriert ist, um die elektronischen Komponenten (14) zu kühlen, indem es mindestens einen Teil der von den elektronischen Komponenten (14) abgegebenen Wärme an die Außenseite des Innenvolumens (10) abführt, wobei das Kühlmodul (24) außerhalb des Innenvolumens (10) angeordnet ist, und
- einen Befestigungsflansch (26), der zwischen das Kühlmodul (24) und die Wand (8) des Elektronikmoduls (6) zwischengestellt ist, wobei der Befestigungsflansch (26) in Kontakt mit dem Kühlmodul (24) und mit der Wand (8) des Elektronikmoduls (6) ist,
**dadurch gekennzeichnet, dass** der Flansch (26) mindestens eine Umfangsfläche (28) umfasst, die sich entlang der Stärke des Flanschs (26) auf der Außenseite des Flanschs (26) erstreckt, und dass sich die Wand (8) gegenüber der Umfangsfläche (28) des Flanschs (26) entlang einer Befestigungsrichtung (F), die im Wesentlichen senkrecht zu der Wand (8) ist, erstreckt und diese abdeckt, wobei die Wand (8) mittels mindestens eines ersten Befestigungselements (30), das sich in der Befestigungsrichtung (F) erstreckt, an der Umfangsfläche (28) des Flanschs (26) befestigt ist.

2. Elektronische Ausrüstung nach Anspruch 1, wobei mehrere Befestigungselemente jede Wand (8) an der Umfangsfläche (28) des Flanschs (26) befestigen.

3. Elektronische Ausrüstung nach Anspruch 1 oder 2, ferner umfassend mindestens ein zweites Befestigungselement (38) umfasst, das konfiguriert ist, um das Elektronikmodul (6) und das Kühlmodul (24) an einer Wand (34) eines Gehäuses (32) zu befestigen, wobei sich das zweite Befestigungselement (38) entlang einer Montagerichtung, die im Wesentlichen senkrecht zu der Befestigungsrichtung (F) ist und sich in das Innenvolumen (10) erstreckt, durch den Flansch (26) erstreckt.

4. Elektronische Ausrüstung nach Anspruch 3, wobei das zweite Befestigungselement (38) eine Sicherheitsbolzen ist.

5. Ausrüstung nach Anspruch 3 oder 4, wobei das zweite Befestigungselement (38) einen Außengewindeendabschnitt (42) und einen Schaftabschnitt (44) mit einem Durchmesser, der kleiner ist als der Durchmesser des Außengewindeendabschnitts (42), umfasst, der Flansch umfassend eine Öffnung (48), die einen Innengewindeabschnitt (50) aufweist, der im Wesentlichen komplementär zu dem Außengewindeendabschnitt (42) ist, wobei das zweite Befestigungselement (38) durch seinen Außengewindeendabschnitt (42) in den Innengewindeabschnitt (50) geschraubt wird und dann nach dem Einschrauben in Bezug auf die Öffnung (48) translatorisch bewegbar ist, da sich der Schaftabschnitt (44) in den Innengewindeabschnitt (50) erstreckt, während er mit dem Flansch (26) fest verbunden bleibt.

6. Elektronische Ausrüstung nach Anspruch 5, wobei die Öffnung (48) einen Abschnitt (52) mit größerem Durchmesser als der Durchmesser des Innengewindeabschnitts (50) aufweist, wobei der Abschnitt (52) mit größerem Durchmesser den Außengewindeendabschnitt (42) des zweiten Befestigungselements (38) aufnimmt, nachdem der Außengewindeendabschnitt (42) in den Innengewindeabschnitt (50) eingeschraubt wurde.

7. Elektronische Ausrüstung nach einem der Ansprüche 3 bis 6, wobei die Wand (34) des Gehäuses (32) eine Öffnung aufweist, wobei der Flansch (26) durch das zweite Befestigungselement (38) an dem Rand (36) der Öffnung befestigt ist, sodass sich das Elektronikmodul (6) auf einer Seite der Wand (34) und das Kühlmodul (24) auf der anderen Seite der Wand (34) erstreckt.

8. Elektronische Ausrüstung nach einem der Ansprüche 1 bis 7, wobei der Flansch (26) eine Stärke im Wesentlichen zwischen 15 mm und 20 mm aufweist.

9. Elektronische Ausrüstung nach einem der Ansprüche 1 bis 8, wobei der Flansch (26) aus einem wärmeisolierenden Material ausgeführt ist.

10. Elektronische Ausrüstung nach einem der Ansprüche 1 bis 9, wobei das Elektronikmodul (6) mindestens vier Seitenwände (8) umfasst, die sich jeweils entlang der Befestigungsrichtung (F) gegenüber einer entsprechenden Umfangsfläche (28) des Umfangs des Flanschs (26) erstrecken, wobei jede Seitenwand (8) durch mindestens ein erstes Befestigungselement (30), das sich in der Befestigungsrichtung (F) erstreckt, an der Umfangsfläche (28) befestigt ist.

11. Elektronische Ausrüstung nach einem der Ansprüche 1 bis 10, wobei das Elektronikmodul (6) ein Wandler elektrischer Energie ist.

## Claims

1. Electronic equipment (4) of a railway vehicle, comprising at least:
- an electronic module (6) comprising at least one wall (8) defining an internal volume (10);
- a set of electronic components (14) arranged within the internal volume (10),
- a cooling module (24), configured to cool the electronic components (14) by discharging at least a portion of a heat dissipated by the electronic components (14) to the outside of the internal volume (10), said cooling module (24) being disposed outside the internal volume (10), and
- a fastening flange (26) interposed between the cooling module (24) and the wall (8) of the electronic module (6), said fastening flange (26) being in contact with the cooling module (24) and with said wall (8) of the electronic module (6),
**characterised in that** the flange (26) comprises at least one peripheral face (28) extending along the thickness of the flange (26) on the outside of the flange (26), and
**in that** the wall (8) extends opposite and covers the peripheral face (28) of the flange (26) in a fastening direction (F) substantially perpendicular to the wall (8), said wall (8) being fastened to said peripheral face (28) of the flange (26) by at least a first fastening member (30) extending in said fastening direction (F).

2. Electronic equipment according to claim 1, wherein a plurality of fastening members fasten each wall (8) to the peripheral face (28) of the flange (26).

3. Electronic equipment according to claim 1 or 2, further comprising at least one second fastening member (38) arranged to fasten the electronic module (6) and the cooling module (24) to a wall (34) of a case (32), said second fastening element (38) extending through the flange (26) in an assembly direction substantially perpendicular to the fastening direction (F) and extending into the internal volume (10).

4. Electronic equipment according to claim 3, wherein the second fastening member (38) is a captive screw.

5. Equipment according to claim 3 or 4, wherein the second fastening member (38) comprises a threaded end portion (42) and a shank portion (44) of a diameter less than the diameter of the threaded end portion (42), the flange comprising an orifice (48) having an internally tapped portion (50) substantially complementary to the threaded end portion (42), the second fastening member (38) being threaded by its threaded end portion (42) into the tapped portion (50) and then being translationally movable relative to the orifice (48) after threading when the shank portion (44) extends into the tapped portion (50) while remaining integral with the flange (26).

6. Electronic equipment according to claim 5, wherein the orifice (48) comprises a portion (52) of a diameter greater than the diameter of the tapped portion (50), said portion (52) of greater diameter receiving the threaded end portion (42) of the second fastening member (38) after said threaded end portion (42) is screwed into the tapped portion (50).

7. Electronic equipment according to any one of claims 3 to 6, wherein the wall (34) of the case (32) comprises an opening, the flange (26) being fastened to the edge (36) of said opening by the second fastening member (38) so that the electronic module (6) extends on one side of the wall (34) and the cooling module (24) on the other side of the wall (34).

8. Electronic equipment according to any one of claims 1 to 7, wherein the flange (26) has a thickness substantially between 15 mm and 20 mm.

9. Electronic equipment according to any one of the claims 1 to 8, wherein the flange (26) is made of a thermally insulating material.

10. Electronic equipment according to any one of claims 1 to 9, wherein the electronic module (6) comprises at least four side walls (8), each extending opposite a corresponding peripheral face (28) of the periphery of the flange (26) in the fastening direction (F), each side wall (8) being attached to the peripheral face (28) by at least a first fastening member (30) extending in said fastening direction (F).

11. Electronic equipment according to any one of claims 1 to 10, wherein the electronic module (6) is an electrical energy converter.
